# EUROPÄISCHE PATENTSCHRIFT

(11) **EP 1 160 863 B1**
(45) Veröffentlichungstag und Bekanntmachung des Hinweises auf die Patenterteilung: **19.12.2007**
(21) Anmeldenummer: 01107349.1
(22) Anmeldetag: 24.03.2001
(51) Int. Cl.: H01L 23/40, H05K 7/20

(54) **Vorrichtung zum Andrücken eines Wärmeleitkörpers**
Pressing device for heat sink
Dispositif pour appliquer un radiateur avec force

(30) Priorität: 27.05.2000 DE 10026348
(43) Veröffentlichungstag der Anmeldung: 05.12.2001
(73) Patentinhaber: SIEMENS AKTIENGESELLSCHAFT, 80333 München (DE)
(72) Erfinder: Spratte, Joachim, 49090 Osnabrück (DE)

(56) Entgegenhaltungen:
- DE-A- 4 226 816
- DE-A- 19 515 073
- DE-U- 29 720 480
- US-A- 4 575 038

## Beschreibung

Die Erfindung betrifft eine Vorrichtung zum Andrücken eines Wärmeleitkörpers auf ein elektronisches Bauteil, welches auf einer Leiterplatte befestigt ist und den weiteren Merkmalen des Oberbegriffs des Anspruchs 1 entspricht.

Eine derartige Vorrichtung ist in der DE 42 26 816 A1 beschrieben. Wärmeleitkörper dienen in elektronischen Schaltungen dazu, die von elektronischen Bauteilen mit hoher Verlustleistung entwickelte Wärme entweder in andere Bauteile, beispielsweise ein Gehäuse, zu leiten oder aber sie sind als Kühlblech ausgebildet und dadurch in der Lage, die von dem Bauteil abgegebene Wärme über eine genügend große Wärmeaustauschfläche unmittelbar an die Umgebungsluft abzugeben.

Um die vom Bauteil erzeugte Wärme möglichst gut aufnehmen zu können, sollen solche Wärmeleitkörper fest gegen das Bauteil anliegen, damit sich ein geringer Wärmeübergangswiderstand ergibt. Hierzu verwendet man bisher üblicherweise Schrauben, die den Wärmeleitkörper gegen das jeweilige Bauteil halten. Man hat in der Praxis auch schon Federn angeordnet, welche einerseits auf dem Wärmeleitkörper, andererseits am die Leiterplatte mit dem Bauteil tragenden Gehäuse abgestützt sind. Die Befestigung von Wärmeleitkörpern mittels Schrauben verlangt einen unerwünscht hohen Montageaufwand. Am Gehäuse und dem Wärmeleitkörper abgestützte Federn erzeugen oftmals keine ausreichend hohen Andrückkräfte, weil die Abstände zwischen dem auf dem elektronischen Bauteil aufliegenden Wärmeleitkörper und dem Gehäuse aufgrund von Toleranzen oftmals erheblich schwanken.

Gemäß der DE 42 26 816 A1 ist die Vorrichtung als eine mit einer Basis über das Bauteil greifende Schenkelfeder ausgebildet, welche im montierten Zustand mit der Basis gegen den Wärmeleitkörper anliegt und zwei durch die Basis miteinander verbundene Schenkel hat, die jeweils durch eine Durchbrechung der Leiterplatte greifen und auf der dem Bauteil gegenüberliegenden Seite der Leiterplatte mit dieser verrastet sind.

Eine solche Schenkelfeder wird somit ausschließlich von der Leiterplatte gehalten. Deshalb beeinflussen Toleranzen des die Leiterplatte tragenden Gehäuses nicht die Andrückkraft der Schenkelfeder auf den Kühlkörper. Da die Schenkelfeder auf der dem Bauteil gegenüberliegenden Seite der Leiterplatte mit dieser verrastet ist, braucht die Schenkelfeder bei der Montage lediglich in die beiden Durchbrechungen eingeschoben zu werden, so dass für ihre Befestigung kein Werkzeug notwendig ist.

Die beiden Schenkel haben dabei an ihrem freien Ende jeweils einen im verrasteten Zustand über die Leiterplatte greifenden Rastvorsprung, wobei die Rastvorsprünge jeweils nach außen gerichtet und die beiden Schenkel in Spreizstellung vorgespannt sind.

Die Basis der Feder ist symmetrisch zueinander von außen nach innen zu dem Bauteil hin eingebuchtet.

Der Erfindung liegt das Problem zugrunde, die Handhabung der Schenkelfeder bei der Montage und Demontage zu vereinfachen.

Zur Lösung des Problems sieht die Erfindung vor, dass die Basis symmetrisch zueinander von außen nach innen - wie beschrieben - zunächst eingebuchtet zu dem Bauteil hin und - zusätzlich - dann zur Bildung eines u-förmigen Griffbereiches mit zwei parallelen Federabschnitten von dem Bauteil weg verläuft.

Die Schenkelfeder ist kostengünstig herzustellen und kann zusätzlich zu dem Wärmeleitkörper oder sogar ausschließlich die Funktion eines Kühlbleches übernehmen, indem man auf den Wärmeleitkörper verzichtet und die Schenkelfeder unmittelbar auf dem Bauteil abstützt, wenn die Schenkelfeder aus einem entsprechend gebogenen Blechstreifen gebildet ist.

Zur weiteren Vereinfachung der Schenkelfeder trägt es bei, wenn die Rastvorsprünge der Schenkelfeder durch jeweils eine Umbiegung des freien Endes jedes Schenkels um mehr als 90° gebildet sind.

Die Erfindung lässt verschiedene Ausführungsformen zu. Zur weiteren Verdeutlichung sind zwei Schenkelfedern in der Zeichnung dargestellt und werden nachfolgend beschrieben. Die Zeichnung zeigt in
- Fig.1: einen Schnitt durch einen Teilbereich einer Leiterplatte mit einem darauf montierten Bauteil, gegen das ein Wärmeleitkörper durch eine Schenkelfeder gehalten ist, wobei die Schenkelfeder keine Ausführungsform der Erfindung darstellt;
- Fig.2: die Anordnung nach Figur 1 mit einer abgewandelten erfindungsgemäßen Ausführungsform der Schenkelfeder.

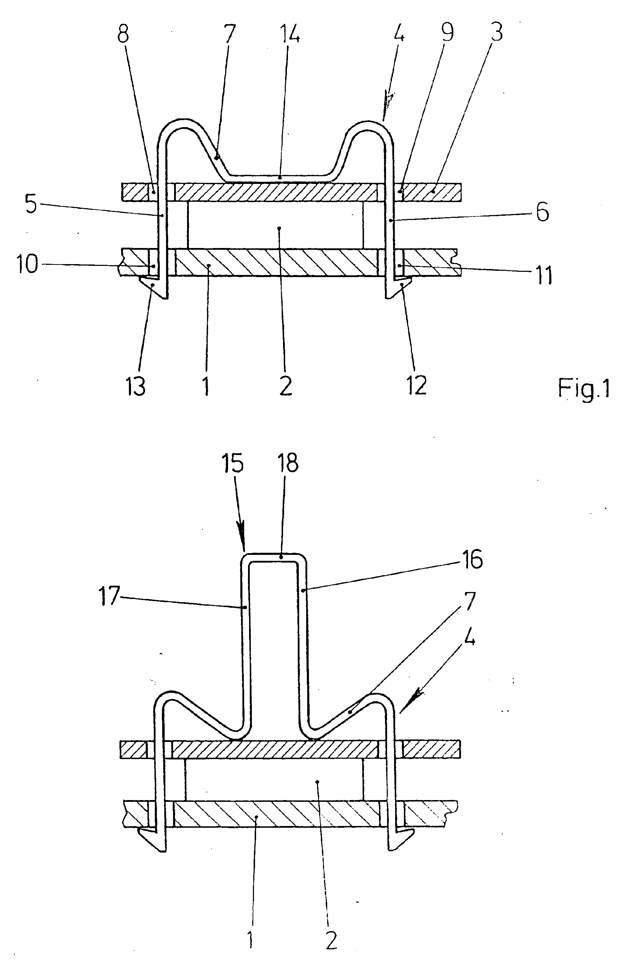

Die Figur 1 zeigt im Schnitt eine Leiterplatte 1, auf der ein elektronisches Bauteil 2 angeordnet ist. Von oben her liegt ein Wärmeleitkörper 3, bei dem es sich um ein übliches Kühlblech handeln kann, flächig auf dem Bauteil 2 auf. Zur Erzeugung der hierzu erforderlichen Andrückkraft dient eine Schenkelfeder 4. Diese ist aus einem Federblechstreifen gebogen und hat zwei Schenkel 5, 6, die durch eine über das Bauteil 2 greifende Basis 7 miteinander verbunden sind.

Der Wärmeleitkörper 3 hat zwei Löcher 8, 9, welche jeweils mit Durchbrechungen 10, 11 der Leiterplatte 1 fluchten. Die Schenkelfeder 4 greift mit ihren beiden Schenkeln 5, 6 jeweils durch ein Loch 8, 9 und eine Durchbrechung 10, 11 und ist auf der dem Bauteil 2 abgewandten Seite der Leiterplatte 1 mit dieser verrastet. Hierzu weisen die freien Enden der Schenkel 5, 6 jeweils einen nach außen gerichteten Rastvorsprung 12, 13 auf, der durch Umbiegen des jeweiligen freien Endes der Schenkel 5, 6 um mehr als 90° gebildet ist.

Die Figur 1 lässt erkennen, dass die Schenkelfeder 4 mit einem eingebuchteten Federbereich 14 von oben her gegen den Wärmeleitkörper 3 anliegt und sich gleichzeitig mit ihren Rastvorsprüngen 12, 13 an der Leiterplatte 1 abstützt. Dadurch ist sie in der Lage, eine hohe Andrückkraft zu erzeugen, welche durch relativ wenige Toleranzen beeinflusst wird.

Bei der erfindungsgemäßen Ausführungsform nach Figur 2 hat die Basis 7 der Schenkelfeder 4 einen u-förmigen Griffbereich 15, der durch zwei parallel von dem Bauteil 2 wegführende Federabschnitte 16, 17 und einen Verbindungsabschnitt 18 gebildet ist. Dieser Griffbereich 15 erleichtert die Handhabung der Schenkelfeder 4.

## Patentansprüche

1. Vorrichtung zum Andrücken eines Wärmeleitkörpers auf ein elektronisches Bauteil, welches auf einer Leiterplatte befestigt ist, wobei die Vorrichtung als eine mit einer Basis (7) über das Bauteil (2) greifende Schenkelfeder (4) ausgebildet ist, welche im montierten Zustand mit der Basis (7) gegen den Wärmeleitkörper (3) anliegt und zwei durch die Basis (7) miteinander verbundene Schenkel (5, 6) hat, die jeweils durch eine Durchbrechung (10, 11) der Leiterplatte (1) greifen und auf der dem Bauteil (2) gegenüberliegenden Seite der Leiterplatte (1) mit dieser verrastet sind, und wobei beiden Schenkel (5, 6) in Spreizstellung vorgespannt sind und an ihrem freien Ende jeweils einen im verrasteten Zustand über die Leiterplatte (1) greifenden Rastvorsprung (12, 13) haben, wobei die Rastvorsprünge (12, 13) jeweils nach außen gerichtet sind und wobei die Basis (7) symmetrisch zueinander von außen nach innen zunächst eingebuchtet zu dem Bauteil (2) hin verläuft, **dadurch gekennzeichnet, dass** sie dann zur Bildung eines u-förmigen Griffbereiches (15) mit zwei parallelen Federabschnitten (16, 17) von dem Bauteil (2) weg verläuft.

2. Vorrichtung nach Anspruch 1, **dadurch gekennzeichnet, dass** die Schenkelfeder (4) aus einem entsprechend gebogenen Blechstreifen gebildet ist.

3. Vorrichtung nach Anspruch 1 oder 2, **dadurch gekennzeichnet, dass** die Rastvorsprünge (12, 13) der Schenkelfeder (4) durch jeweils eine Umbiegung des freien Endes jedes Schenkels (5, 6) um mehr als 90° gebildet sind.

## Claims

1. Device for pressing a heat-conducting body against an electronic component attached to a printed circuit board, the device taking the form of a leg spring (4) extending with a base (7) over the component (2), which leg spring (4) rests, when fitted, with its base (7) against the heat-conducting body (3) and has two legs (5, 6) connected together by the base (7), which legs (5, 6) each extend through an opening (10, 11) in the printed circuit board (1) and are latched together therewith on the opposite side of the printed circuit board (1) from the component (2), and the two legs (5, 6) being biased in the spread position and each having at their free ends a latching projection (12, 13) engaging in the latched state over the printed circuit board (1), the latching projections (12, 13) each being directed outwards and the base (7) extending mutually symmetrically from the outside inwards with initial indentations towards the component (2), **characterized in that** it then extends away from the component (2) with two parallel spring portions (16, 17) to form a U-shaped handle area (15).

2. Device according to Claim 1, **characterized in that** the leg spring (4) is formed from an appropriately bent metal strip.

3. Device according to Claim 1 or 2, **characterized in that** the latching projections (12, 13) of the leg spring (4) are each formed by bending the free end of each leg (5, 6) over by more than 90°.

## Revendications

1. Dispositif destiné à appliquer avec force un radiateur thermique sur un composant électronique fixé sur une carte à circuits imprimés, où le dispositif est conçu sous la forme d'un ressort à branches (4) prenant prise par une base (7) sur le composant (2) et qui, dans l'état installé, est appliqué par la base (7) contre le radiateur thermique (3) et a deux branches (5, 6) liées l'une à l'autre par la base (7) qui s'engagent à travers une ouverture (10, 11) dans la carte à circuits imprimés (1) et s'encliquettent avec la carte à circuits imprimés (1) sur son côté faisant face au composant (2) et où les deux branches (5, 6) sont soumises à une force de précontrainte en position écartée et ont, à leur extrémité libre, chacune un ergot d'arrêt (12, 13) prenant prise, dans l'état encliqueté, sur la carte à circuits imprimés (1), les ergots d'arrêt (12, 13) étant chacun dirigés vers l'extérieur et la base (7) se développant, d'abord d'une façon incurvée vers le composant (2), symétriquement de l'extérieur vers l'intérieur, **caractérisé par le fait que**, ensuite, elle se développe en s'éloignant du composant (2) pour former une zone de saisie (15) en forme de U avec deux sections élastiques parallèles (16, 17).

2. Dispositif selon la revendication 1, **caractérisé par le fait que** le ressort à branches (4) est formé par une bande de tôle pliée en conséquence.

3. Dispositif selon la revendication 1 ou 2, **caractérisé par le fait que** les ergots d'arrêt (12, 13) du ressort à branches (4) sont formés chacun par un pliage de l'extrémité libre de chaque branche (5, 6) de plus de 90°.
